**Europäisches Patentamt**

**European Patent Office**

**Office européen des brevets**

(11) Veröffentlichungsnummer: **0 419 692 A1**

# (12) EUROPÄISCHE PATENTANMELDUNG

(21) Anmeldenummer: **89117692.7**

(22) Anmeldetag: **25.09.89**

(51) Int. Cl.5: **H01L 31/103, H01L 31/109**

(43) Veröffentlichungstag der Anmeldung:
**03.04.91 Patentblatt 91/14**

(84) Benannte Vertragsstaaten:
**DE FR GB IT**

(71) Anmelder: **Siemens Aktiengesellschaft**
**Wittelsbacherplatz 2**
**W-8000 München 2(DE)**

(72) Erfinder: **Münzer, Adolf, Dipl.-Phys.**
**Orleansstrasse 67**
**W-8000 München 80(DE)**

(54) **Infrarot-Detektor und Herstellungsverfahren dazu.**

(57) Ein Infrarot-Halbleiter-Detektor mit einem ladungstrennenden pn-Übergang soll mit geringem Aufwand und mit geringen Kosten hergestellt werden können. Der ladungstrennende pn-Übergang ist näher an der dem Lichteinfall abgewandten Seite des Detektors als an der dem Lichteinfall zugewandten Seite des Detektors angeordnet.

FIG 1

## INFRAROT-DETEKTOR UND HERSTELLUNGSVERFAHREN DAZU

Die Erfindung betrifft einen Infrarot-Halbleiter-Detektor mit einem ladungstrennenden pn-Übergang nach dem Oberbegriff des Patentanspruchs 1 und ein Verfahren zu seiner Herstellung.

Bisher werden Infrarot (IR)-Halbleiter-Sensoren für nahes Infrarot-Licht auf Siliziumbasis in Diodenform oder in Transistorform unter Verwendung entsprechender zusätzlicher Filterelemente hergestellt. Um dabei ein hohes Signal-Rausch-Verhältnis zu erzielen, wird hierfür vor allem hochohmiges Halbleiter-Basismaterial verwendet, was niedrige Dunkelströme als Rauschsignal und gleichzeitig hohe Signalströme aufgrund großer Diffusionslängen bzw. aufgrund guter Rot-Empfindlichkeit der konventionellen Dioden oder Transistoren liefert. Der verwendete spektrale Bereich kann dabei auch durch speziell auf den gewünschten Spektralbereich hin angepasste Vergütungsschichten herausgefiltert werden.

Der vorliegenden Erfindung liegt die Aufgabe zugrunde, einen Infrarot-Halbleiter-Detektor der eingangs genannten Art und ein Verfahren zu seiner Herstellung anzugeben, welche nur einen geringen Aufwand und geringe Kosten erfordern.

Diese Aufgabe wird erfindungsgemäß durch einen Infrarot-Halbleiter-Detektor nach dem Patentanspruch 1 und durch Herstellungsverfahren nach den Patentansprüchen 3 bis 5 gelöst.

Die Erfindung beruht auf der Ausnutzung des Absorptions-Verhaltens von Licht in Silizium-Material. Aufgrund des AbsorptionsKoeffizienten wird kurzwelliges Licht sehr schnell, d. h. bereits nahe an der dem Licht zugewandten Silizium-Oberfläche absorbiert. Hingegen wird langwelliges Licht erst viel weiter im Inneren des Silizium-Materials absorbiert und zur Erzeugung von Elektron-Loch-Paaren verwendet. Ob die bei der Absorption des jeweiligen Lichts erzeugten Ladungsträger dabei den ladungstrennenden pn-Übergang erreichen, ist abhängig von der Diffusionslänge dieser Ladungsträger und von den vorhandenen Verluststrom-Mechanismen.

Beim Stand der Technik ist der ladungstrennende pn-Übergang an der dem Lichteinfall zugewandten Oberfläche angeordnet. Bei der Erfindung hingegen ist der ladungstrennende pn-Übergang von der dem Lichteinfall zugewandten Vorderseite des Halbleiter-Detektors auf die dem Lichteinfall abgewandte Rückseite verlegt. Dadurch ist die Wahrscheinlichkeit der Ladungsträgereinsammlung für tief im Siliziummaterial erzeugte Ladungsträger (z. B. infolge von Absorption von Rotlicht) größer als für nahe an der dem Lichteinfall zugewandten Oberfläche des Halbleiterdetektors erzeugten Ladungsträger (z. B. infolge von Absorption von Blaulicht).

Der spektrale Ansprechbereich eines derartigen Halbleiterdetektors nach der Erfindung kann über die Diffusionslänge der Minoriätsladungsträger, über die Dicke von Halbleiterscheiben, die zur Herstellung des Halbleiterdetektors verwendet werden, und über Oberflächeneffekte wie z. B. Oberflächenrekombination variiert bzw. festgelegt werden.

Diese Parameter sind technologisch beeinflußbar. Z. B. kann die Diffusionslänge durch enstprechende Wahl des zur Herstellung des Halbleiterdetektors und/oder durch entsprechende Prozeßführung bei der Herstellung des Halbleiterdetektors festgelegt bzw. beeinflußt werden. Beispielsweise kann die Dicke der zur Herstellung des Hallbeiterdetektors vewendeten Halbleiterscheibe durch mechanischen oder chemischen Abtrag eingestellt werden. Beispielsweise kann die Oberflächenrekombination durch mechanische oder chemische Aufrauhung der Oberfläche des zur Herstellung des Halbleiterdetektors verwendeteten HalbleiterMaterials, durch Erzeugung von Damage an der Oberfläche des zur Herstellung des Halbleiterdetektors verwendeten Halbleitermaterials, durch zusätzliche Dotierung und/oder durch zusätzliche, dem Fachmann bekannte Maßnahmen festgelegt bzw. beeinflußt werden. Auch eine Kombination von angegebenen und/oder dem Fach mann bekannten Maßnahmen zur Variation bzw. zur Festlegung dieser Parameter zur Beeinflußung des spektralen Ansprechbereichs des Halbleiterdetektors sind möglich.

Die Erfindung ermöglicht einen kostengünstigen Infrarot-Detektor mit einfachem Aufbau und ein kostengünstiges und einfaches Verfahren zur Herstellung eines solchen Detektors. Bei einem Halbleiter-Detektor nach der Erfindung wird ein aufwendiges Filterelement bzw. eine aufwendige Vergütungsschicht zur Festlegung eines bestimmten Spektralbereiches, der bevorzugt vom Halbleiter-Detektor detektiert wird, unnötig.

Die Erfindung wird im folgenden anhand der Zeichnung näher erläutert.

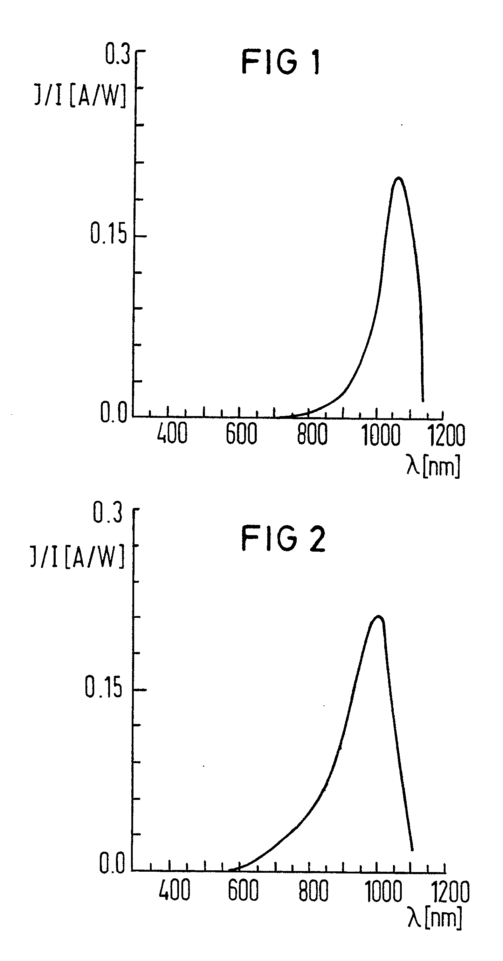

FIG 1 und 2 zeigen spektrale Empfindlichkeiten für Infrarot-Dioden nach der Erfindung.

FIG 1 zeigt eine typische spektrale Empfindlichkeit für eine Infrarot-Diode nach der Erfindung. Die maximale Empfindlichkeit liegt dabei bei etwa 1060 nm. Die Dicke der zur Herstellung dieser Infrarot-Diode verwendeten Silizium-Halbleiterscheibe beträgt etwa 400 μm.

Die spektrale Lage des Maximums der spektralen Empfindlichkeit ist durch Variation der Dicke der zur Herstellung der Infrarot-Diode verwendeten Halbleiterscheibe beeinflußbar. Minoritätsträger-Lebensdauern und Oberflächenrekombination bestimmen die Breitbandigkeit bzw. das Sperrverhalten bei kleinen Wellenlängen des absorbierten Lichts.

Die Infrarot-Dioden nach den FIG 1 und 2 wurden mit einem Verfahren nach der Erfindung hergestellt. Die spektrale Empfindlichkeit im angestrebten (gewünschten) Wellenlängenbereich entsprach dabei der spektralen Empfindlichkeit für konventionelle Fotodioden, die nach demselben Herstellungsverfahren hergestellt worden sind, bei denen jedoch der ladungstrennende pn-Übergang auf der dem Lichteinfall zugewandten Vorderseite des Detektors angeordnet ist und bei denen entsprechende Filterelemente bzw. Vergütungsschichten verwendet werden. Bei Infrarot-Dioden nach der Erfindung war lediglich die Ansprechwahrscheinlichkeit im Blaubereich je nach Herstellungsart der Infrarot-Diode gemäß der Erfindung im Vergleich zu konventionellen Fotodioden nach dem Stand der Technik unterdrückt. FIG 1 zeigt die typische spektrale Empfindlichkeit für Infrarot-Dioden nach der Erfindung.

Neben der Beeinflußbarkeit der Breitbandigkeit aufgrund von Beeinflussung von Diffusionslängen und Oberflächen-Rekombinationseffekten kann auch die spektrale Lage des Maximums der spektralen Empfindlichkeit mit Hilfe der Variation der Dicke des zur Herstellung des Halbleiter-Detektors verwendeten Halbleitermaterials variiert werden. Ein Vergleich zwischen den FIG 1 und 2 zeigt diese Abhängigkeit der spektralen Lage des Maximums der spektralen Empfindlichkeit für unterschiedliche Scheibendicken. FIG 2 zeigt die spektrale Empfindlichkeit für eine Infrarot-Diode, die nach demselben Herstellungsverfahren wie eine Infrarot-Diode nach FIG 1 hergestellt worden ist, mit der einzigen Ausnahme, daß zur Herstellung der Infrarot-Diode nach FIG 2 eine Dicke der zur Herstellung dieser Infrarot-Diode nach FIG 2 verwendeten Halbleiterscheibe von ca. 200 $\mu$m verwendet wurde. Dabei ergibt sich eine Verschiebung der Wellenlänge für die maximale Empfindlichkeit zu ca. 1000 nm hin. Auf diese Weise ist eine spektrale Anpassung von Infrarot-Detektoren nach der Erfindung an entsprechende Sender, z. B. auf Silizium-Basis oder auf Verbindungshalbleiter-Basis, beispielsweise auf GaAs-Basis, möglich.

Wie zu erwarten ist, ist die Ansprechwahrscheinlichkeit der Infrarot-Diode nach FIG 2 im Blaubereich größer als die Ansprechwahrscheinlichkeit der Infrarot-Diode nach FIG 1.

**Ansprüche**

1. Infrarot-Halbleiter-Detektor mit einem ladungstrennenden pn-Übergang,
**dadurch gekennzeichnet,** daß der ladungstrennende pn-Übergang näher an der dem Lichteinfall abgewandten Seite des Detektors als an der dem Lichteinfall zugewandten Seite des Detektors angeordnet ist.

2. Infrarot-Halbleiter-Detektor nach Anspruch 1,
**dadurch gekennzeichnet,** daß der ladungstrennende pn-Übergang an der dem Lichteinfall abgewandten Seite des Detektors angeordnet ist.

3. Verfahren zur Herstellung eines Infrarot-Halbleiter-Detektors nach Anspruch 1 oder 2,
**dadurch gekennzeichnet,** daß der spektrale Ansprechbereich des Detektors über die Diffusionslänge der Minoritätsladungsträger durch entsprechende Wahl des Halbleiter-Materials und/oder entsprechende Prozeßführung festgelegt wird.

4. Verfahren zur Herstellung eines Infrarot-Halbleiter-Detektors nach einem der Ansprüche 1 bis 3,
**dadurch gekennzeichnet,** daß der spektrale Ansprechbereich des Detektors über die Dicke des Halbleiter-Materials, aus dem der Detektor hergestellt wird, durch mechanische und/oder chemische Abtragung festgelegt wird.

5. Verfahren zur Herstellung eines Infrarot-Halbleiter-Detektors nach einem der Ansprüche 1 bis 4,
**dadurch gekennzeichnet,** daß der spektrale Ansprechbereich des Detektors über die Oberflächenrekombination durch mechanische und/oder chemische Aufrauhung der Oberfläche des Detektors und/oder durch Erzeugung von Damage im Detektor-Material und/oder durch zusätzliche Dotierung des Detektors-Materials festgelegt wird.

# FIG 1

# FIG 2

**Europäisches Patentamt**

# EUROPÄISCHER RECHERCHENBERICHT

Nummer der Anmeldung

EP 89 11 7692

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | DE-A-3 213 226 (LICENTIA PATENT-VERWALTUNG GmbH) * Das ganze Dokument * --- | 1-5 | H 01 L 31/103 H 01 L 31/109 |
| X | JOURNAL OF APPLIED PHYSICS, Band 57, Nr. 8, Teil 1, 15. April 1985, Seiten 2671-2694, American Institute of Physics, Woodbury, New York, US; M.A. HERMAN et al.: "Hg1-xCdxTe-Hg1-yCdyTe($0<x,y<1$) heterostructures: Properties, epitaxy, and applications" * Seite 2682, linke Spalte, Zeile 22 - Seite 2683, linke Spalte, Zeile 17; Figur 12c * --- | 1,2 | |
| A | APPLIED PHYSICS LETTERS, Band 48, Nr. 14, 7. April 1986, Seiten 903-904, American Institute of Physics, Woodbury, New York, US; A.K. SRIVASTAVA et al.: "High performance GaInAsSb/GaSb p-n photodiodes for the 1.8-2.3 mum wavelenght range" * Das ganze Dokument * --- | 1-5 | RECHERCHIERTE SACHGEBIETE (Int. Cl.5) H 01 L |
| A | APPLIED PHYSICS LETTERS, Band 26, Nr. 8, 15. April 1975, Seiten 438-441, American Institute of Phyiscs, New York, US; A.M. ANDREWS et al.: "Backside-illuminated Pb1-xSnxTe heterojunction photodiode" * Das ganze Dokument * ---                       -/- | 1-5 | |

Der vorliegende Recherchenbericht wurde für alle Patentansprüche erstellt

| Recherchenort | Abschlußdatum der Recherche | Prüfer |
|---|---|---|
| DEN HAAG | 08-05-1990 | LINA F. |

**KATEGORIE DER GENANNTEN DOKUMENTE**

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus andern Gründen angeführtes Dokument
...............................................................
& : Mitglied der gleichen Patentfamilie, übereinstimmendes
Dokument

EPO FORM 1503 03.82 (P0403)

Europäisches
Patentamt

**EUROPÄISCHER RECHERCHENBERICHT**

Nummer der Anmeldung

EP  89 11 7692

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | JAPANESE JOURNAL OF APPLIED PHYSICS, SUPPLEMENTS OF THE 16TH INTERNATIONAL CONFERENCE ON SOLID STATE DEVICES AND MATERIALS, Kobe, 1. September 1984, Seiten 659-662, Tokyo, JP; K. MATSUSHITA et al.: "Application of plasma-assisted epitaxial GaSb to photoelectronic devices" * Seite 660; Figur 3 *<br>----- | 1,2 | |
| | | | **RECHERCHIERTE SACHGEBIETE (Int. Cl.5)** |

Der vorliegende Recherchenbericht wurde für alle Patentansprüche erstellt

| Recherchenort | Abschlußdatum der Recherche | Prüfer |
|---|---|---|
| DEN HAAG | 08-05-1990 | LINA F. |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
.............................................................................
& : Mitglied der gleichen Patentfamilie, übereinstimmendes
    Dokument

EPO FORM 1503 03.82 (P0403)